# FASCICULE DE BREVET EUROPEEN

(11) **EP 1 227 590 B1**
(45) Date de publication et mention de la délivrance du brevet: **01.08.2012**
(21) Numéro de dépôt: 02290054.2
(22) Date de dépôt: 10.01.2002
(51) Int. Cl.: H03K 17/725, H05B 37/02, H02M 3/155

(54) **Procédé et dispositif d'élaboration d'une tension d'alimentation nécessaire au pilotage d'un interrupteur électronique**
Verfahren und Vorrichtung zum Aufbereiten von einer zum Betrieb eines elektronischen Schalters nötigen Versorgungsspannung
Method and apparatus for generating a supply voltage necessary for the operation of an electronic switch

(30) Priorité: 10.01.2001 FR 0100267
(43) Date de publication de la demande: 31.07.2002
(73) Titulaire: Legrand France, 87000 Limoges (FR); Legrand SNC, 87000 Limoges (FR)
(72) Inventeur: Pelletier, Laurence, 71250 Salornay sur Guye (FR); Delaporte, Alain, 87220 Aureil (FR)
(74) Mandataire: Santarelli

(56) Documents cités:
- EP-A- 0 031 626
- EP-A- 0 637 874
- WO-A-89/08351
- US-A- 4 504 778
- US-A- 4 678 985
- US-A- 5 838 555

## Description

L'invention concerne un procédé et un dispositif d'élaboration d'une tension d'alimentation, nécessaire pour alimenter les moyens de commande d'un interrupteur électronique, par exemple du genre triac ou analogue. Elle vise plus particulièrement à élaborer une telle tension continue propre à alimenter des circuits électroniques de pilotage lorsque ledit interrupteur est câblé en deux fils pour commander l'alimentation d'une charge (telle que par exemple une lampe d'éclairage) c'est-à-dire plus particulièrement lorsqu'il est connecté en série avec ladite charge entre la phase et le neutre d'un réseau de distribution de courant alternatif monophasé.

Dans le contexte indiqué ci-dessus, l'interrupteur électronique (le triac) remplace l'interrupteur classique à contact métallique. Il est donc placé avec ses circuits électroniques de commande dans un boîtier encastré dans le mur où ne parviennent le plus souvent que deux fils que l'on appellera ici par commodité la "phase" et la "phase coupée". L'interrupteur électrique est bien entendu connecté entre les deux fils disponibles, c'est-à-dire entre ladite phase et ladite phase coupée. La charge est quant à elle connectée entre le fil dit "phase coupée" et le neutre qui n'est pas accessible.

Or, il est nécessaire de disposer d'une tension continue de quelques Volts, par exemple 5 Volts, pour alimenter les circuits électroniques de pilotage de l'interrupteur. La configuration de câblage indiquée ci-dessus n'est pas favorable pour pouvoir extraire une telle tension continue des deux fils disponibles dans le boîtier encastré dans le mur.

Le document EP 0 031 626 décrit néanmoins un circuit d'alimentation en courant continu, pour le pilotage d'un triac, qui prélève l'énergie électrique nécessaire sur le réseau à l'aide d'un condensateur et d'un circuit redresseur. Ce circuit ne peut élaborer une tension continue exploitable que si le triac est bloqué. Par conséquent, la solution proposée dans ce document antérieur consiste à interrompre la conduction du triac à chaque alternance, pendant un court intervalle de temps nécessaire à l'élaboration d'une tension continue exploitable pour l'alimentation des circuits de pilotage dudit triac.

Ce type de solution qui consiste à créer périodiquement une "butée de conduction" dans la commande du triac génère des parasites qui nécessitent l'utilisation d'un filtre coûteux et encombrant pour que le système soit conforme aux normes en vigueur.

Le document US 5 838 555 décrit aussi un tel circuit.

Le document EP 0 637 874 décrit un circuit d'alimentation en courant continu, pour le pilotage d'un MOSFET, qui prélève l'énergie nécessaire du potentiel aux bornes du MOSFET dans l'état conducteur. Néanmoins ce circuit n'est pas utile pour un réseau de distribution de courant alternatif.

L'invention propose une autre solution qui consiste à exploiter la tension résiduelle aux bornes de l'interrupteur commandé lorsque celui-ci est conducteur.

Plus particulièrement, l'invention concerne un procédé d'élaboration d'une tension d'alimentation auxiliaire nécessaire au pilotage d'un interrupteur électronique connecté en série avec une charge à un réseau de distribution de courant alternatif monophasé, caractérisé en ce que, pendant les périodes de temps où ledit interrupteur électronique est en état de conduction, on prélève l'énergie électrique nécessaire à l'élaboration de ladite tension d'alimentation auxiliaire aux bornes dudit interrupteur électronique en exploitant une chute de tension résiduelle disponible entre lesdites bornes.

Dans la pratique, cette chute tension résiduelle alternative est de l'ordre du Volt. Il est donc avantageux de redresser et élever cette chute de tension résiduelle, par exemple au moyen d'un circuit redresseur-élévateur de tension, d'un type connu. On peut ainsi obtenir une tension de l'ordre de 5 Volts ou plus, parfaitement utilisable pour l'alimentation en courant continu des circuits de pilotage de l'interrupteur électronique.

Si on connecte à la sortie dudit redresseur-élévateur de tension un élément capacitif, voire un petit accumulateur électrochimique, il est possible de conserver une tension exploitable pendant les périodes de temps où l'interrupteur électronique n'est pas en état de conduction (interrupteur ouvert) et par conséquent de pouvoir alimenter normalement les circuits de pilotage dudit interrupteur électronique au moment d'une remise en conduction du triac, c'est-à-dire lorsqu'on désire alimenter la charge. Cependant, il est avantageux, pendant les périodes de temps où l'interrupteur électronique est bloqué, d'élaborer la tension d'alimentation auxiliaire directement à partir de la tension du réseau puisque, lorsque l'interrupteur électronique est bloqué (c'est-à-dire ouvert), la tension du réseau de distribution de courant alternatif peut être exploitée pour élaborer directement ladite tension d'alimentation auxiliaire, au moyen, par exemple, d'un simple circuit redresseur connecté à la phase par un condensateur.

L'invention concerne également un dispositif de commande d'alimentation électrique pour une charge, du type comportant un interrupteur électronique commandé destiné à être connecté en série avec ladite charge pour son alimentation par un réseau de distribution de courant alternatif monophasé et des moyens de commande dudit interrupteur, caractérisé en ce qu'il comporte un premier circuit d'alimentation auxiliaire en courant continu, connecté pour alimenter lesdits moyens de commande, en ce que ce premier circuit comporte une entrée d'énergie électrique en courant alternatif et en ce que lesdits moyens de commande sont agencés pour connecter ladite entrée aux bornes dudit interrupteur électronique lorsqu'il est à l'état passant.

Comme mentionné précédemment, ledit premier circuit d'alimentation auxiliaire comportera de préférence un redresseur-élévateur de tension. Ce dispositif pourra par exemple être du type alimentation à découpage, régulée.

A titre d'exemple, on propose dans le commerce des circuits intégrés spécialement conçus pour réaliser un redresseur-élévateur de tension du type mentionné.

Par exemple, la firme "LINEAR TECHNOLOGY®" propose un circuit intégré référence LT1073-5 spécialement conçu pour cet usage.

De préférence, le dispositif défini ci-dessus est aussi caractérisé en ce qu'il comporte un second circuit d'alimentation auxiliaire en courant continu, relié en entrée audit réseau de distribution de courant alternatif et agencé pour alimenter lesdits moyens de commande lorsque ledit interrupteur électronique n'est pas en état de conduction.

Ce second circuit d'alimentation auxiliaire consiste en un simple redresseur relié au réseau de distribution par un condensateur.

L'invention apparaîtra plus clairement à la lumière de la description qui va suivre d'un dispositif électronique de commande d'alimentation électrique pour une charge alimentée en courant alternatif, donnée uniquement à titre d'exemple et faite en référence aux dessins annexés dans lesquels :
- la figure 1 est un schéma de principe du dispositif électronique ; et
- la figure 2 est un chronogramme illustrant la tension alternative disponible aux bornes de l'interrupteur électronique lorsque celui-ci est en état de conduction.

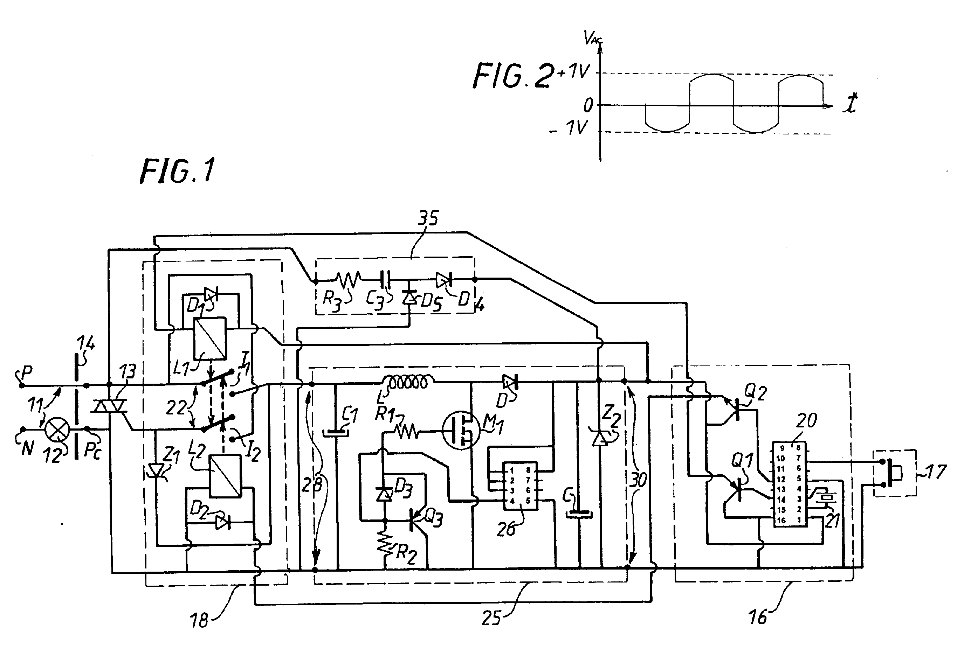

En considérant la figure 1, on a schématisé un réseau de distribution de courant alternatif monophasé 11 équipant par exemple un local. On distingue une phase P et un neutre N. Une charge 12 en l'occurrence ici, une lampe d'éclairage, peut être alimentée en courant alternatif à partir de ce réseau. La charge peut être n'importe quel appareil électrique prévu pour être alimenté en courant alternatif.

Pour ce faire, un interrupteur électronique 13, du type triac, est connecté en série avec ladite charge et l'ensemble est connecté entre la phase P et le neutre N.Cependant, à l'emplacement où l'interrupteur électronique est installé, c'est-à-dire par exemple dans un boîtier encastré dans le mur, il n'y a que deux fils disponibles, à savoir, par exemple, la phase et la phase coupée Pc, selon la définition qui précède. Le triac 13 est connecté entre ces deux fils. La phase coupée est quant à elle reliée à la charge 12. Le neutre N n'est pas accessible directement à l'emplacement où se trouve l'interrupteur électronique.

La commande dudit interrupteur électronique 13 nécessite des moyens de commande électroniques nécessitant, pour leur fonctionnement, une tension continue d'alimentation.

Dans l'exemple, les moyens de commande du triac comprennent un circuit de pilotage 16 lui-même piloté par une interface-utilisateur 17 ainsi qu'une interface de connexion 18 commandée par ledit circuit de commande.

Le circuit de pilotage 16 comporte essentiellement un microcontrôleur 20. On peut par exemple utiliser le microcontrôleur 8 bits, portant la référence ST6200 fabriqué par SGS THOMSON®. Il est ici connecté d'une façon classique préconisée par le constructeur. Son fonctionnement nécessite l'adjonction d'un quartz 21. Il comporte deux sorties logiques respectivement connectées aux bases de deux transistors Q1, Q2. Le transistor Q1 est du type PNP et le transistor Q2 est du type NPN. Ces deux transistors pilotent respectivement deux bobines L1 (enclenchement) et L2 (déclenchement) d'un relais bistable 22 à deux interrupteurs I1, I2, qui constitue l'essentiel de l'interface de connexion 18 installée entre le triac 13 et un premier circuit d'alimentation auxiliaire en courant continu 25, constituant la particularité essentielle de l'invention.

Dans l'exemple décrit, l'interface-utilisateur 17 se réduit à un simple bouton-poussoir connecté entre une entrée du microcontrôleur et ladite phase coupée Pc. Il est à noter cependant que l'intérêt d'un tel système est de pouvoir associer au microcontrôleur tout type d'interface utilisateur, par exemple un récepteur infrarouge, un réflecteur HF, ou autre.

La tension continue disponible à la sortie dudit premier circuit d'alimentation auxiliaire 25 permet d'alimenter aussi bien les composants du circuit de pilotage 16 que les bobines du relais 22. Le montage de l'interface de connexion est le suivant. La phase P est reliée à un pôle de chaque interrupteur I1, I2. La gâchette du triac est reliée à l'autre pôle de l'interrupteur I2.

Par ailleurs, ledit premier circuit d'alimentation auxiliaire 25 porte une entrée d'énergie électrique en courant alternatif 28 (sous forme d'un dipôle) qui est connectée à l'autre pôle de l'interrupteur I1 et à la phase coupée Pc, c'est-à-dire le conducteur accessible relié à la lampe 12.

Comme il ressort clairement de la figure 1, le branchement des deux interrupteurs I1, I2 est tel que, dans l'une des positions (interrupteurs I1, I2 ouverts), la phase P n'est connectée ni à l'entrée d'énergie électrique 28, ni à la gâchette du triac 13. Dans l'autre position (interrupteurs I1, I2 fermés), ladite entrée d'énergie électrique est connectée entre la phase et la phase coupée, c'est-à-dire aux bornes du triac 13 et la phase est connectée à la gâchette du triac.

Comme indiqué précédemment, le relais 22 est du type bistable. Il est alimenté seulement lors des changements d'état. Il s'agit ici d'un relais à alimentation en courant continu. Ce relais présente la particularité d'avoir deux bobines : L1 pour l'enclenchement et L2 pour le déclenchement. Le fait d'alimenter la bobine L2, déclenche le relais et ouvre les deux interrupteurs L1 et L2. La bobine L1 est connectée entre la sortie de tension continue dudit premier circuit d'alimentation auxiliaire et l'émetteur du transistor Q1. La bobine L2 est connectée entre l'émetteur du transistor Q2 et ladite phase coupée Pc. Une diode D1, D2 est connectée en parallèle sur chaque bobine L1, L2 pour les protéger contre les surtensions au moment du blocage du transistor Q1, Q2 qui la commande. Une diode Zener Z1 est connectée entre la gâchette du triac et l'entrée d'énergie électrique 28 (l'anode étant du côté gâchette). Le rôle de cette diode Zener est de protéger le premier circuit d'alimentation auxiliaire 25. Plus précisément, si l'interrupteur I1 est fermé lorsque le triac est bloqué (ce qui est un disfonctionnement) la Zener amorce le triac, ce qui permet d'éviter que la tension alternative du réseau de distribution soit appliquée à l'entrée d'énergie électrique 28, ce qui provoquerait la destruction dudit premier circuit d'alimentation auxiliaire 25. Ce dernier comporte un dipôle de sortie 30 aux bornes duquel une tension continue, de l'ordre de 5 Volts, est disponible pour alimenter les moyens de commande du triac, c'est-à-dire essentiellement ici, le relais 22 et le circuit de pilotage 16. L'un des pôles du dipôle de sortie est relié à la phase coupée.

Le premier circuit d'alimentation auxiliaire 25 est agencé en redresseur-élévateur de tension comprenant une self-inductance L et une diode D montées en série ainsi qu'un condensateur C connecté en parallèle au dipôle de sortie 30. Ces composants sont connectés à un circuit intégré 26 (type LT 1073, par exemple) conçu pour constituer une alimentation à découpage associée à des moyens de régulation. La self-inductance L est connectée entre la borne de l'entrée 28 qui est reliée à l'interrupteur I1 et l'anode de la diode D. Un transistor M1 de type MOS, a sa liaison drain-source connectée entre le point commun de la self-inductance L et de la diode D et ladite phase coupée. Sa grille est connectée à une résistance R1 dont la borne opposée est connectée à l'émetteur d'un transistor Q3. Le collecteur de ce transistor est connecté à ladite phase coupée. Une diode D3 est connectée entre le collecteur et la base du transistor Q3. Une résistance de polarisation R2 est connectée entre la base de ce transistor et ladite phase coupée. La base du transistor Q3 est connectée à une sortie du circuit intégré. Celui-ci est aussi relié (sortie 8) à la cathode de la diode D. Le transistor M1 est en fait un commutateur extérieur utilisé de préférence à celui qui est prévu dans le circuit intégré, pour obtenir une meilleure efficacité. La partie de circuit comprenant le transistor Q3, la diode D3 et la résistance R2 ne constitue qu'un système d'aide à l'ouverture du transistor M1. Un condensateur C1 de forte valeur est connecté en parallèle sur l'entrée 28 pour assurer le redressement monoalternance de la tension aux bornes du dipôle et éliminer les "retours HF" vers le réseau de distribution de courant alternatif. La tension continue d'alimentation auxiliaire est disponible aux bornes du dipôle de sortie 30, c'est-à-dire entre la cathode de la diode D et ladite phase coupée. Une diode Zener Z2 agissant en limiteur de tension est connectée en parallèle sur le condensateur C. Le fonctionnement de l'alimentation auxiliaire sera décrit plus en détail ci-dessous.

La tension d'alimentation auxiliaire disponible au dipôle de sortie 30 permet d'alimenter à la fois le circuit de pilotage 16 et le relais 22. Plus précisément, la cathode de la diode D est reliée à l'entrée d'alimentation (entrée 1) du microcontrôleur 20, au collecteur du transistor Q2 et à la bobine L1 du relais 22. Le premier circuit d'alimentation auxiliaire 25 est ici conçu pour élaborer ladite tension auxiliaire seulement lorsque le triac 13 est conducteur. Lorsque le triac est bloqué, cette tension auxiliaire est élaborée par un second circuit d'alimentation auxiliaire 35, beaucoup plus simple, qui comporte une branche série comprenant une résistance R3, un condensateur C3 et une diode D4. L'autre borne de la résistance R3 est reliée au triac 13, du côté phase. La cathode de la diode D4 est connectée à la sortie du premier circuit d'alimentation auxiliaire 25, c'est-à-dire plus précisément à la cathode de la diode D. Une diode D5 a sa cathode connectée entre le point commun du condensateur C3 et de la diode D4 et son anode connectée à ladite phase coupée.

Le fonctionnement est le suivant. Lorsque l'utilisateur commande l'alimentation de la lampe 12 en agissant sur ladite interface utilisateur 17, le circuit de pilotage 16 provoque l'enclenchement du relais 22. La gâchette du triac 13 est commandée et celui-ci entre en conduction. La lampe 12 est alimentée. Dans ces conditions, on sait qu'il subsiste aux bornes du triac une chute de tension alternative d'environ 1 Volt, comme représenté à la figure 2. Cette tension résiduelle, du fait que l'interrupteur I1 est fermé, se retrouve aux bornes de l'entrée 28. A chaque période de découpage, la self-inductance L se charge à travers le transistor M1 quand il est à l'état passant puis, à l'ouverture de ce même transistor, l'énergie accumulée dans la self-inductance est transférée vers le condensateur C via la diode D. La surtension créée permet de charger le condensateur C jusqu'à une tension de l'ordre de 5 volts, qui est suffisante pour alimenter les moyens de commande 16, 18.

Lorsque l'utilisateur commande l'extinction de la lampe 12 en agissant sur ladite interface utilisateur 17, le circuit de pilotage provoque le déclenchement du relais, les interrupteurs I1 et I2 s'ouvrent, le triac se bloque, l'alimentation auxiliaire 25 est neutralisée. En revanche, la charge du condensateur C est maintenue via le second circuit d'alimentation auxiliaire 35. Ce dernier se comporte comme un redresseur-abaisseur de tension qui peut développer une tension redressée suffisante dès lors que le triac 13 est bloqué puisque, dans ces conditions, une tension alternative du réseau de distributeur est disponible à l'entrée du circuit d'alimentation auxiliaire 35.

## Revendications

1. Procédé d'élaboration d'une tension d'alimentation auxiliaire nécessaire au pilotage d'un interrupteur électronique connecté en série avec une charge (12) à un réseau de distribution de courant alternatif monophasé, **caractérisé en ce que**, pendant les périodes de temps où ledit interrupteur électronique (13) est en état de conduction, on prélève l'énergie électrique nécessaire à l'élaboration de ladite tension d'alimentation auxiliaire aux bornes dudit interrupteur électronique en exploitant une chute de tension résiduelle, disponible entre lesdites bornes.

2. Procédé selon la revendication 1, **caractérisé en ce qu'**on redresse et élève (25) ladite chute de tension, jusqu'à disposer de ladite tension d'alimentation auxiliaire.

3. Procédé selon la revendication 1 ou 2, **caractérisé en ce qu'**on élabore (35) ladite tension d'alimentation auxiliaire à partir de la tension dudit réseau pendant les périodes de temps où ledit interrupteur électronique est bloqué.

4. Dispositif électronique de commande d'alimentation électrique pour une charge (12), du type comportant un interrupteur électronique (13) commandé destiné à être connecté en série avec ladite charge pour son alimentation par un réseau de distribution de courant alternatif monophasé et des moyens de commande (16, 17, 18) dudit interrupteur, **caractérisé en ce qu'**il comporte un premier circuit d'alimentation auxiliaire en courant continu (25), connecté pour alimenter lesdits moyens de commande, **en ce que** ce premier circuit comporte une entrée d'énergie électrique en courant alternatif (28) et **en ce que** lesdits moyens de commande sont agencés pour connecter ladite entrée aux bornes dudit interrupteur électronique (13) lorsqu'il est à l'état passant.

5. Dispositif selon la revendication 4, **caractérisé en ce que** ledit premier circuit d'alimentation auxiliaire (25) comporte un redresseur-élévateur de tension.

6. Dispositif selon la revendication 5, **caractérisé en ce que** ledit redresseur-élévateur de tension est du type alimentation à découpage régulée.

7. Dispositif selon l'une des revendications 4 à 6, **caractérisé en ce que** lesdits moyens de commande comportent une interface de connexion (18) commandée, interconnectée entre ledit interrupteur électronique (13) et ladite entrée d'énergie électrique en courant alternatif (28).

8. Dispositif selon la revendication 7, **caractérisé en ce que** ladite interface de connexion comporte un relais électromagnétique (22) comprenant un premier interrupteur (I1) connecté entre ladite entrée d'énergie électrique (28) et ledit interrupteur électronique (13).

9. Dispositif selon revendications 4 à 8 **caractérisé en ce que** ledit interrupteur électronique (13) est du type triac ou analogue.

10. Dispositif selon l'ensemble des revendications 8 et 9, **caractérisé en ce que** ledit relais électromagnétique comporte un second interrupteur (I2) connecté entre la phase et l'électrode de commande dudit interrupteur électronique.

11. Dispositif selon l'une des revendications 8 à 10, **caractérisé en ce que** ledit relais électromagnétique (22) est du type bistable.

12. Dispositif selon la revendication 11, **caractérisé en ce que** ledit relais électromagnétique (22) comporte deux bobines (L1, L2) respectivement alimentées par l'intermédiaire de deux interrupteurs commandés (Q1, Q2) faisant partie d'un circuit de pilotage (16), lui-même piloté par une interface-utilisateur (17).

13. Dispositif selon l'une des revendications 4 à 12; **caractérisé en ce qu'**il comporte un second circuit d'alimentation auxiliaire en courant continu (35), relié en entrée audit réseau de distribution de courant alternatif et agencé pour alimenter lesdits moyens de commande lorsque ledit interrupteur électronique (13) n'est pas en état de conduction.

14. Dispositif selon la revendication 13, **caractérisé en ce que** ledit second circuit d'alimentation auxiliaire consiste en un redresseur relié audit réseau de distribution par une résistance (R3) et un condensateur (C3).

## Claims

1. A method of producing an auxiliary power supply voltage necessary for controlling an electronic switch connected in series with a load (12) to a single-phase alternating current mains supply, **characterised in that**, during the periods of time in which said electronic switch (13) is in a conducting state, the electrical energy necessary for producing said auxiliary power supply voltage is taken from the terminals of said electronic switch using a residual voltage drop available between said terminals.

2. The method according to claim 1 **characterised in that** said voltage drop is rectified and stepped up (25), to obtain said auxiliary power supply voltage.

3. The method according to claim 1 or 2 **characterised in that** said auxiliary power supply voltage is produced (35) from the voltage of said mains supply during the periods of time in which said electronic switch is turned off.

4. An electronic device for controlling an electrical power supply for a load (12), of the type comprising a controlled electronic switch (13) adapted to be connected in series with said load to supply it with power from a single phase alternating current mains supply and control means (16, 17, 18) for said switch, **characterised in that** it comprises a first auxiliary direct current power supply circuit (25), connected to supply power to said control means, and **in that** said first circuit comprises an alternating current electrical energy input (28) and **in that** said control means are arranged to connect said input to the terminals of said electronic switch (13) when it is in the on state.

5. The device according to claim 4 **characterised in that** said first auxiliary power supply circuit (25) comprises a rectifier/voltage step-up converter.

6. The device according to claim 5 **characterised in that** said rectifier/voltage step-up converter is of the regulated switch mode power supply type.

7. The device according to one of claims 4 to 6, **characterised in that** said control means comprise a controlled connection interface (18) interconnected between said electronic switch (13) and said alternating current electrical energy input (28).

8. The device according to claim 7 **characterised in that** said connection interface comprises an electromagnetic relay (22) comprising a first switch (11) connected between said electrical energy input (28) and said electronic switch (13).

9. The device according to claims 4 to 8, **characterised in that** said electronic switch (13) is of the triac type or the like.

10. The device according to the set of claims 8 and 9, **characterised in that** said electromagnetic relay comprises a second switch (12) connected between live and the control electrode of said electronic switch.

11. The device according to one of claims 8 to 10, **characterised in that** said electromagnetic relay (22) is of the bistable type.

12. The device according to claim 11, **characterised in that** said electromagnetic relay (22) comprises two coils (L1, L2) respectively energized via two controlled switches (Q1, Q2) forming part of a control circuit (16), itself controlled via a user interface (17).

13. The device according to one of claims 4 to 12 **characterized in that** it comprises a second direct current auxiliary power supply circuit (35), connected as input to said alternating current mains supply and arranged to supply power to said control means when said electronic switch (13) is not in a conducting state.

14. The device according to claim 13, **characterised in that** said second auxiliary power supply circuit consists of a rectifier connected to said mains supply by a resistor (R3) and a capacitor (C3).

## Patentansprüche

1. Verfahren zur Ausarbeitung einer Hilfsversorgungsspannung, die zum Ansteuern eines elektronischen Schalters erforderlich ist, der in Reihe mit einer Last (12) an ein Verteilungsnetz für Einphasenwechselstrom angeschlossen ist, **dadurch gekennzeichnet, dass** während der Zeiträume, bei denen der elektronische Schalter (13) im leitenden Zustand ist, die zur Ausarbeitung der Hilfsversorgungsspannung erforderliche elektrische Energie an den Anschlussklemmen des elektronischen Schalters entnommen wird, indem ein Spannungsabfall einer Restspannung genutzt wird, die zwischen den Anschlussklemmen verfügbar ist.

2. Verfahren nach Anspruch 1,
**dadurch gekennzeichnet, dass** der Spannungsabfall gleichgerichtet und angehoben wird (25), bis die Hilfsversorgungsspannung verfügbar ist.

3. Verfahren nach Anspruch 1 oder 2,
**dadurch gekennzeichnet, dass** die Hilfsversorgungsspannung ausgehend von der Spannung des Netzes während der Zeiträume aufbereitet wird (35), bei denen der elektronische Schalter gesperrt ist.

4. Elektronische Vorrichtung zum Steuern der Stromversorgung für eine Last (12), vom Typ enthaltend einen ansteuerbaren elektronischen Schalter (13), der dazu bestimmt ist, in Reihe mit der Last zu dessen Versorgung durch ein Verteilungsnetz für Einphasenwechselstrom angeschlossen zu werden, sowie Steuermittel (16, 17, 18) des Schalters, **dadurch gekennzeichnet, dass** sie einen ersten Hilfsversorgungskreis für Gleichstrom (25) aufweist, der dazu vorgesehen ist, die Steuermittel zu versorgen, dass dieser erste Kreis einen Elektroenergieeingang für Wechselstrom (28) aufweist, und dass die Steuermittel dazu vorgesehen sind, den Eingang mit den Anschlussklemmen des elektronischen Schalters (13) dann zu verbinden, wenn er im Durchlasszustand ist.

5. Vorrichtung nach Anspruch 4,
**dadurch gekennzeichnet, dass** der erste Hilfsversorgungskreis (25) einen Gleichrichter-Spannungserhöher aufweist.

6. Vorrichtung nach Anspruch 5,
**dadurch gekennzeichnet, dass** der Gleichrichter-Spannungserhöher als geregeltes Schaltnetzteil aufgeführt ist.

7. Vorrichtung nach einem der Ansprüche 4 bis 6,
**dadurch gekennzeichnet, dass** die Steuermittel eine ansteuerbare Verbindungsschnittstelle (18) aufweisen, die zwischen den elektronischen Schalter (13) und den Elektroenergieeingang für Wechselstrom (28) zwischenverbunden ist.

8. Vorrichtung nach Anspruch 7,
**dadurch gekennzeichnet, dass** die Verbindungsschnittstelle ein elektromagnetisches Relais (22) aufweist, das einen ersten Schalter (I1) verbunden ist, der zwischen den Elektroenergieeingang (28) und den elektronischen Schalter (13) verbunden ist.

9. Vorrichtung nach einem der Ansprüche 4 bis 8,
**dadurch gekennzeichnet, dass** der elektronische Schalter (13) als Triac oder dergleichen ausgeführt ist.

10. Vorrichtung nach Anspruch 8 und 9 zusammengenommen,
**dadurch gekennzeichnet, dass** das elektromagnetische Relais einen zweiten Schalter (I2) aufweist, der zwischen die Phase und die Steuerelektrode des elektronischen Schalters verbunden ist.

11. Vorrichtung nach einem der Ansprüche 8 bis 10,
**dadurch gekennzeichnet, dass** das elektromagnetische Relais (22) bistabil ausgeführt ist.

12. Vorrichtung nach Anspruch 11,
**dadurch gekennzeichnet, dass** das elektromagnetische Relais (22) zwei Spulen (L1, L2) aufweist, die über zwei jeweilige ansteuerbare Schalter (Q1, Q2) gespeist werden, die zu einem Steuerkreis (16) gehören, der seinerseits über eine Anwenderschnittstelle (17) angesteuert wird.

13. Vorrichtung nach einem der Ansprüche 4 bis 12,
**dadurch gekennzeichnet, dass** sie einen zweiten Hilfsversorgungskreis für Gleichstrom (35) aufweist, der am Eingang mit dem Verteilungsnetz für Wechselstrom verbunden ist und dazu vorgesehen ist, die Steuermittel dann zu versorgen, wenn der elektronische Schalter (13) nicht im leitenden Zustand ist.

14. Vorrichtung nach Anspruch 13,
**dadurch gekennzeichnet, dass** der zweite Hilfsversorgungskreis aus einem Gleichrichter besteht, der über einen Widerstand (R3) und einen Kondensator (C3) mit dem Verteilungsnetz verbunden ist.
